# EUROPEAN PATENT SPECIFICATION

(11) **EP 0 576 082 B1**
(45) Date of publication and mention of the grant of the patent: **27.03.2002**
(21) Application number: 93201754.4
(22) Date of filing: 18.06.1993
(51) Int. Cl.: H04B 1/26, H03J 7/02, H03D 3/00

(54) **FM receiver including a phase quadrature IF filter**
FM-Empfänger mit Phasenquadratur-MF-Filter
Récepteur FM muni d'un filtre MF à quadrature de phase

(30) Priority: 26.06.1992 EP 92201907
(43) Date of publication of application: 29.12.1993
(73) Proprietor: Koninklijke Philips Electronics N.V., 5621 BA Eindhoven (NL)
(72) Inventor: Kianush, Kaveh, NL-5656 AA Eindhoven (NL); Bijker, Wolter, NL-5656 AA Eindhoven (NL); Kasperkovitz, Wolfdietrich Georg, NL-5656 AA Eindhoven (NL); De Ruyter, Hendricus Clemens, NL-5656 AA Eindhoven (NL); Sloof, Willem Arie, NL-5656 AA Eindhoven (NL)
(74) Representative: Groenendaal, Antonius Wilhelmus Maria

(56) References cited:
- WO-A-90/13175
- GB-A- 2 242 588
- US-A- 4 079 330
- MILLMAN & HALKIAS: 'INTEGRATED ELECTRONICS; Analog and Digital circuits', 1983, MCGRAW-HILL

## Description

The invention relates to an FM receiver as defined in the preamble of claim 1.

FM receivers of the above-mentioned type are known *per se* as superheterodyne FM receivers.

It is known to realize a high intermediate frequency (IF) selectivity so as to avoid disturbances of the signal processing in the known FM receiver as much as possible. However, complex IF filters which are difficult to integrate and hence costly are required for this purpose. The use of active integrated and hence low-cost filters is not possible in the known FM receiver concept without making concessions to the IF selectivity and/or the dynamic range.

In fact, the usual requirements regarding the dynamic range in FM receivers imposes a given upper limit on the quality factor Q of the IF filter. To satisfy the conflicting requirements of a sufficient by large dynamic range on the one hand and a high selectivity on the other hand when using small and hence easily integrable capacitances, there is currently a tendency to realize the IF selectivity at the lowest possible intermediate frequency. However, the further decrease of the resonance frequency of a conventional IF filter is accompanied by a growing asymmetry in the amplitude or response characteristic around the resonance frequency so that there is a strong increase of the second-order distortion in particular.

It is an object of the invention to enhance the selectivity and the degree of integration of the known FM receiver while maintaining a sufficiently large dynamic range.

An FM receiver according to the invention is characterized as defined in the characterizing part of claim 1.

The invention is based on the recognition that a low-distortion selection of an FM IF signal at a comparatively low intermediate frequency can be realized in a simpler manner with a polyphase filter rather than with a single-phase filter, because the bandpass characteristic of a single-phase filter at lower values of the resonance frequency cannot or can only hardly be made symmetrical around this resonance frequency, whereas this is possible in know manner with a polyphase filter. Such polyphase filters are known, for example from European Patent Applications EP 0 344 852 and EP 0420 974.

The measure according to the invention includes a signal conversion from single phase to phase quadrature so as to make the use of said polyphase filter possible and hence either enhance the selectivity in the case of an equal distortion or reduce the distortion in the case of an equal selectivity, or by enhancing the selectivity and reducing the distortion as compared with the known FM receiver, while maintaining the dynamic range. The use of one or more resonance amplifiers as IF selectivity in an FM receiver is known per se from the last-mentioned European Patent Application EP 0 420 974. However, the measure of using such resonance amplifiers as IF polyphase filters of the phase-quadrature type provides the possibility of choosing the second intermediate frequency to be considerably lower than has hitherto been conventional practice in known FM receivers of the superheterodyne type while maintaining a symmetrical bandpass characteristic and a point-symmetrical phase characteristic. A further integration of the IF filter is thereby possible, while maintaining a low-distortion IF signal selection.

When this measure is used, the tuning frequency of each one of the two first and second resonance amplifiers instantaneously follows the modulation signal of the IF signal. With respect to the situation without tuning control, the bandwidth of these resonance amplifiers may be further narrowed, which enhances the IF selectivity, and a much smaller part of the transfer characteristic of the resonance amplifiers is traversed by the IF signal to be selected which results in a considerable reduction of distortion. Simultaneously, instabilities in the tuning control are obviated.

By making the bandwidth of the first timing control loop larger than that of the second control loop the stability in each one of the first and second tuning control loops is increased.

A preferred embodiment of the FM receiver according to the invention, in which an accurate signal conversion from single phase to phase quadrature is obtained in a simple manner, comprises the features of claim 2.

A further preferred embodiment of an FM receiver according to the invention, in which due to a neighboring transmitter coming within the capturing range of the tuning control loop as a result of an instantaneously occurring large frequency deviation and being dominant in this loop with respect to the desired transmitter, it is prevented that the tuning control captures the desired tuning and is drawn away from this tuning by this unwanted neighboring transmitter, comprises the features of claim 3.

A further preferred embodiment of an FM-receiver according to the invention comprises the features of claim 4. In this respect the gain characteristic function of the first and second amplifier-limiters corresponds to that of each one of the two first and second tuning control loops and the second amplifier-limiter as well as the last-mentioned amplifier-limiter influence the loop gain of both the first and the second tuning control loop.

For a further improvement of the tuning control a preferred embodiment of the last-mentioned FM receiver according to the invention comprises the features of claim 5.

When this measure is used, the bandwidth of each resonance amplifier can be set to a bandwidth which is favourable for a suitable neighbouring selection, without any loss of stability.

A preferred embodiment of an FM receiver according to the invention, which can easily be realised in practice, is characterized in that the frequency demodulator comprises a multiplier circuit and a frequency-dependent phase shifter, in which the polyphase IF filter is coupled to a first input of the multiplier circuit and to a second input of the multiplier circuit *via* the frequency-dependent phase shifter, said frequency-dependent phase shifter comprising a resonance amplifier.

These and other aspects of the invention will be apparent from and elucidated with reference to the embodiments described hereinafter. Elements corresponding in function have the same reference indications. In the drawings:
Fig. 1 shows an FM receiver according to the invention;
Fig. 2 shows an amplifier-limiter for use in the FM receiver of Fig. 1;
Figs. 3A-3C show three embodiments of a tuning control signal generating circuit for use in the FM receiver of Fig. 1;
Fig. 4 shows the gain characteristic of an amplifier-limiter for use in the FM receiver of Fig. 1 as a function of the input signal amplitude;
Fig. 5 shows amplitude and phase characteristics of a conventional LC filter and a resonance amplifier.

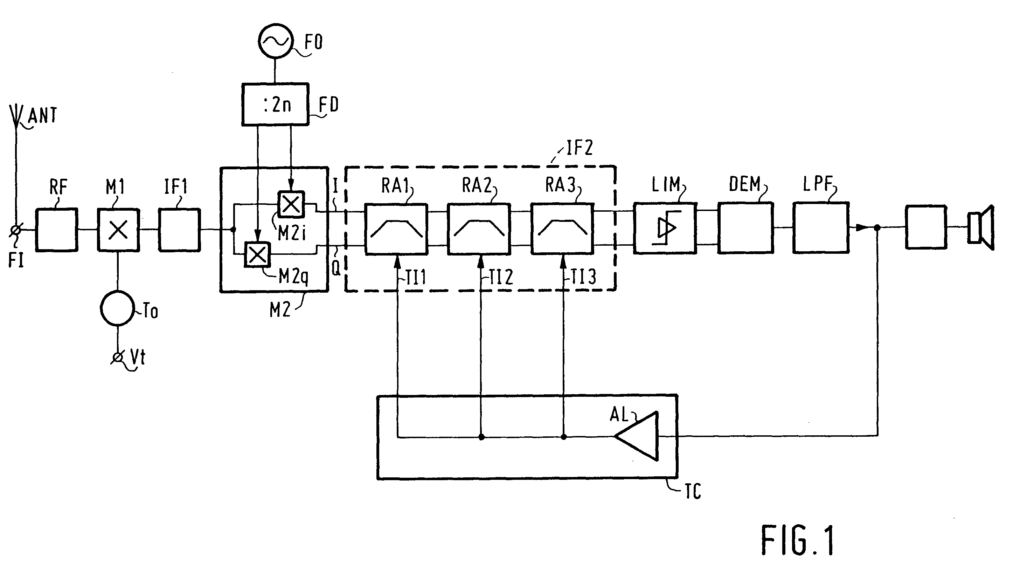

Fig. 1 shows an FM receiver according to the invention, comprising a radio-frequency (RF) antenna input RFI for connecting an antenna ANT thereto, to which an RF input section RF for RF amplification and selection of a desired RF FM reception signal is coupled, followed by means M1, IF1, M2 for a down-conversion of a desired RF FM reception signal to an intermediate frequency, and comprising a tunable first mixer stage M1 to which a tunable oscillation signal is applied from a tuning oscillator TO for tuning to and frequency conversion of the desired RF FM reception signal to a first intermediate frequency (IF) signal having a carrier frequency located on average at a first intermediate frequency f1, and comprising a first IF section IF1 for selecting the first IF signal, followed by a second mixer stage M2 for a down-conversion of the first IF signal to a second IF signal having on average a carrier frequency located at a second intermediate frequency f2.

The tuning oscillator TO is tuned to a frequency which deviates by the value of f1 from that of the carrier frequency of the desired RF FM reception signal by means of a tuning voltage applied *via* a tuning control terminal Vt, while a mixing signal having a fixed oscillator frequency deviating by the value of f2 from the first intermediate frequency f1 is applied to the second mixer stage M2 from a fixed local oscillator device LO.

The down-conversion in the second mixer stage M2 is accompanied by a conversion from single phase to phase quadrature. To this end the second mixer stage M2 comprises an in-phase multiplier circuit M2i and a quadrature multiplier circuit M2q to which the first IF signal on the one hand and in-phase and quadrature mixing signal components from a fixed local oscillator device LO on the other hand are applied in common. These in-phase and quadrature mixing signal components are obtained by dividing the frequency of the oscillator signal from a fixed oscillator FO by a correct even factor in a frequency divider FD. In a practical embodiment the first intermediate frequency was 10.7 MHz, the second intermediate frequency was 300 kHz, the oscillator frequency of the FO was 22 MHz and the division factor of the FD was 2.

The second mixer stage M2 has in-phase and quadrature outputs which are coupled *via* in-phase and quadrature signal paths I and Q to a cascade arrangement, functioning as a tunable second IF filter IF2, of first to third tunable resonance amplifiers RA1-RA3 for selecting the second IF signal. Such resonance amplifiers are known *per se* from European Patent Application EP 0 420 974 and are particularly suitable to be integrated. It is known from the last-mentioned Patent Application that resonance amplifiers in their relevant use as tunable polyphase filters of the phase-quadrature type have a linear tuning behaviour, also at very low values of the resonance frequency fres and a bandpass characteristic which is symmetrical around fres and a point-symmetrical phase characteristic, so that a low- distortion selection is obtained. The average value of the resonance frequency fres corresponds to that of the second intermediate frequency f2.

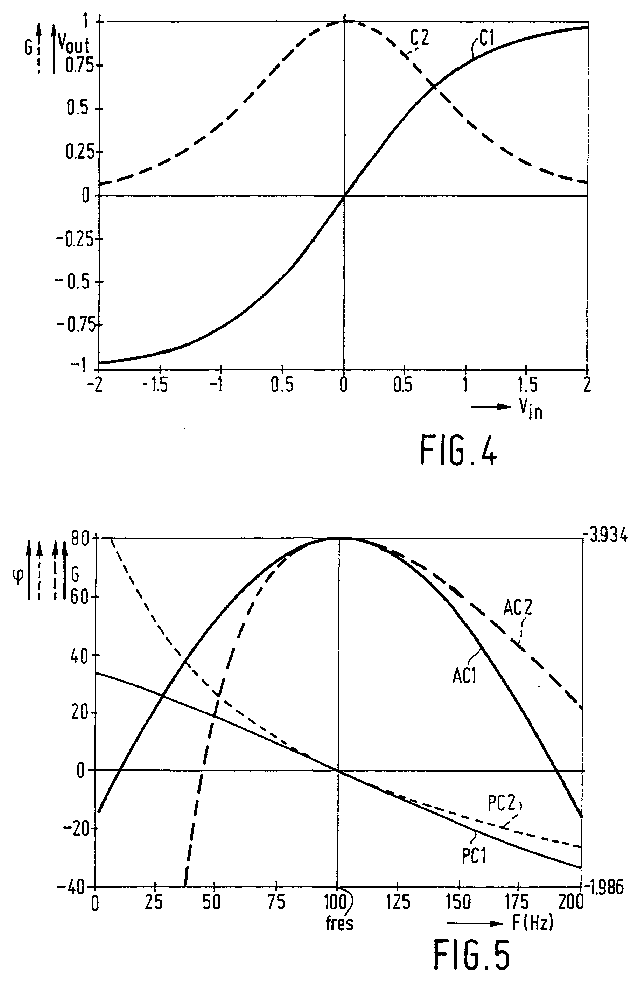

For the purpose of illustration Fig. 5 shows by means of curves AC1 and AC2 the bandpass or amplitude characteristic and by means of curves PC1 and PC2 the phase transfer characteristic of a resonance amplifier in the relevant use as a phase-quadrature filter and a conventional LC filter, respectively, each around an equal resonance frequency fres. Curves AC1 and AC2 clearly illustrate that a resonance amplifier in the mentioned use has a symmetrical amplitude characteristic and a conventional LC filter has an asymmetrical amplitude characteristic around fres. Curves PC1 and PC2 illustrate that such a resonance amplifier has a point-symmetrical phase characteristic and a conventional LC filter has a more or less quadratic phase characteristic around fres.

The tunable second IF filter IF2 is coupled to a phase-quadrature FM demodulator DEM *via* a limiter LIM. This limiter LIM eliminates unwanted amplitude variations on the second IF signal. The FM demodulator DEM precedes a low-pass filter LPF for selecting the baseband modulation signal, a baseband modulation signal processing device ASP for processing the baseband signal and the audio modulation signal, and a sound reproducing device L for reproducing the desired audio signal. The phase-quadrature FM demodulator DEM may be of a known type and use, for example, only one of the two in-phase and quadrature components of the second IF signal as an input signal, or it may have a structure known from German Patent Application no. 26 36 268.

An output of the low-pass filter LPF is also coupled to an amplifier-limiter AL incorporated in a tuning control signal generating circuit TC, an output of said amplifier-limiter being connected in common to tuning control inputs TI1-TI3 of the respective first to third resonance amplifiers RA1-RA3. The amplifier-limiter AL is used for an amplification and a gradual limitation (soft limiting) to be described hereinafter of the IF filter tuning control signal.

First to third IF tuning control loops are obtained *via* the coupling of the tuning control signal generating circuit TC to each one of the first to third resonance amplifiers RA1-RA3, which tuning control loops instantaneously vary the tuning frequency of each one of the first to third resonance amplifiers RA1-RA3 with the baseband modulation signal of the second IF signal. To obtain a sufficient loop stability, the open loop gain in each one of the first to third IF tuning control loops should be smaller than one. This can be achieved in a simple manner by choosing the gain of the AL to have a suitable value which is smaller than one.

Due to the instantaneous control of each one of the first to third resonance amplifiers RA1-RA3, the effective bandwidth of the cascade circuit of RA1-RA3 can be chosen to be considerably smaller than the bandwidth of the baseband modulation signal so that a comparatively high IF selectivity is feasible without any loss of useful signal information.

In view of the symmetrical amplitude characteristic of each one of the first to third resonance amplifiers RA1-RA3, substantially no distortion is introduced.

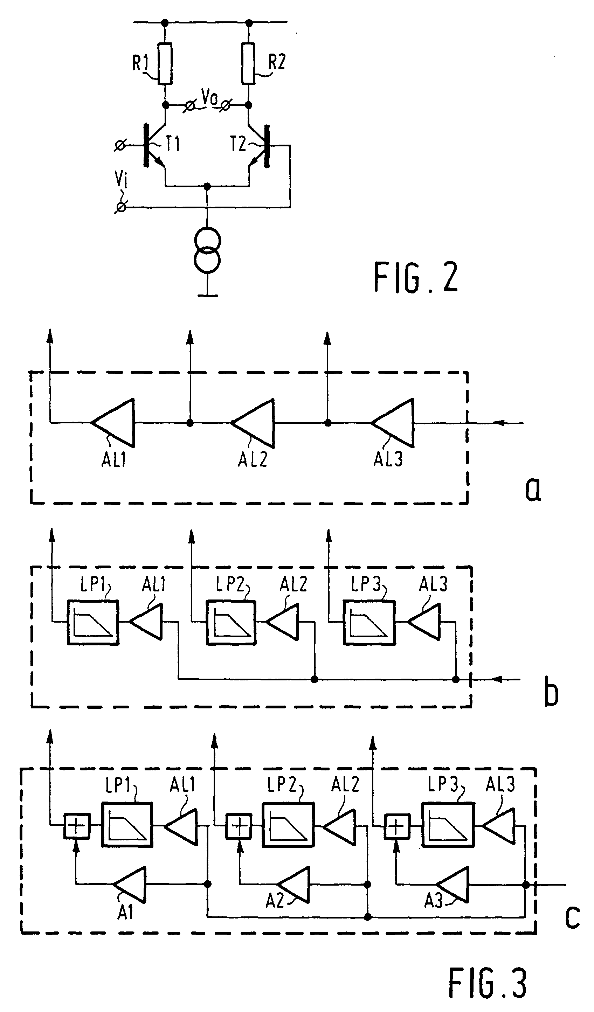

The gain of the amplifier-limiter AL gradually decreases at an increasing input voltage in such a manner that the output voltage increases at an increasing value of the input voltage, for example, in accordance with a tangent hyperbola function and due to saturation phenomena when an input voltage increasing towards infinity asymptotically approximates a given limitation value. The choice of the limitation value will hereinafter be described in greater detail. A transistor difference pair is shown in Fig. 2 and has an emitter coupled transistor pair T1, T2 with a common emitter current source and collector resistors R1 and R2. In the embodiment shown without emitter resistors said tangent hyperbola function is obtained. One may deviate therefrom by using emitter resistors while maintaining the character of a gradual limitation. The amplifier-limiter AL shown supplies an output voltage and a gain which vary as a function of the input voltage, as is shown by means of curves C1 and C2, respectively, in Fig. 4. The realisation and the operation of such an amplifier-limiter as well as its behaviour at a varying input voltage are known to those skilled in the art and do not require any further description for understanding the invention.

Due to the limitation of the output signal of the amplifier-limiter AL at an output signal of the FM demodulator DEM increasing an amplitude, and when the IF tuning control loop captures an unwanted neighbouring transmitter carrier, the IF filter RA1-RA3 will only follow the frequency modulation of this neighbouring transmitter carrier in so far and as long as this frequency modulation takes place within the control range of the first to third tuning control loops. If the neighbouring transmitter carrier exceeds this control range, the tuning control will be maintained and the IF filter RA1-RA3 will remain at the tuning frequency determined by the limitation level of the IF tuning control signal. When the desired carrier re-appears within the tuning control range of the first to third IF tuning control loops in the last-mentioned position of the IF filter RA1-RA3, the IF filter RA1 -RA3 will follow this desired carrier in tuning frequency again and the desired tuning control is thereby restored. Since the amplifier-limiter AL gradually decreases in gain when the amplitude of the demodulator output signal increases, an effective reduction of interference due to capturing phenomena is obtained.

The FM demodulator DEM preferably comprises a resonance amplifier (not shown) as a tunable frequency-dependent phase shifting circuit so that a reliable manufacture of the FM receiver shown is possible in a simple manner by means of matching with the first to third resonance amplifiers RA1-RA3.

The use of circuits having mutually corresponding operations, such as the first tunable resonance amplifier RA1 and the second tunable resonance amplifier RA2, the first amplifier-limiter AL1 and the second amplifier-limiter AL2, the in-phase and quadrature multiplier circuits in the second mixer stage M2 and the multiplier circuit M3, and the common use of circuits in the two tuning control loops provides a considerable matching and hence a simple and accurate manufacture.

Improvements of the tuning control behaviour while maintaining the stability are possible by deriving, in the tuning control signal generating circuit TC, an individually adapted tuning control signal from the output signal, selected in the low-pass filter LPF, of the FM demodulator DEM for each one of the first, second and third tuning control loops. The loop gain, loop bandwidth and/or stability may then be optimized for each tuning control loop.

Generally, the open loop gain in each tuning control loop should be smaller than one for the purpose of a satisfactory loop stability, while the phase shift in the tuning control loops should be such that a frequency tracking of the resonance amplifiers is obtained at which the tuning of the resonance amplifiers follows the frequency modulation of the second IF signal substantially instantaneously in frequency.

Fig. 3A shows a first preferred embodiment of the tuning control signal generating circuit TC comprising a cascade arrangement of first to third amplifier-limiters AL1-AL3, outputs of which are connected to the tuning control inputs TI1, TI2 and TI3. The open loop gain in each one of the first, second and third tuning control loops is smaller than one and that of the first tuning control loop is smaller than that of the second tuning control loop, while that of the second tuning control loop is smaller than that of the third tuning control loop. The gain factor of each one of the first to third amplifier-limiters AL1-AL3 should then preferably be smaller than one.

Fig. 3B shows a second preferred embodiment of the tuning control signal generating circuit TC in which first, second and third cascade arrangements of the first, second and third amplifier-limiters AL1, AL2 and AL3 with first, second and third low-pass filters LF1, LF2 and LF3 used as first, second and third loop filters are used for deriving individual tuning control signals for the first, second and third tuning control loops. Inputs of the first amplifier-limiter AL1, the second amplifier-limiter AL2 and the third amplifier-limiter AL3 are connected in common to the output of the LPF, while outputs of the first loop filter LF1, the second loop filter LF2 and the third loop filter LF3 are connected to the tuning control inputs TI1, TI2 and TI3, respectively. The gain of the first amplifier-limiter AL1 is preferably smaller than that of the second amplifier-limiter AL2 and the gain of the second amplifier-limiter AL2 is smaller than that of the third amplifier-limiter AL3, while the bandwidths of the first to third loop filters LF1-LF3 are mutually of the same order of magnitude.

Fig. 3C shows a third preferred embodiment of the tuning control signal generating circuit TC in which the first, the second and the third cascade arrangements of the first amplifier-limiter AL1 with the first loop filter LF1, the second amplifier-limiter AL2 with the second loop filter LF2 and the third amplifier-limiter AL3 with the third loop filter LF3 are dimensioned in a corresponding manner as in the embodiment of Fig. 3B and which are shunted by means of respective amplifier stages A1, A2 and A3. The gain factor of A3 should then be preferably smaller than that of A2 and the gain factor of A2 should be smaller than that of A1. A shunt path for the higher frequencies of the tuning control signals is formed by the amplifier stages A1, A2 and A3.

It will be evident that the invention is not limited to the embodiment shown. For example, it is possible to realise a phase split by means of a resonance amplifier, preceded by a single-phase tunable mixer stage, to use a conventional FM quadrature demodulator instead of the FM demodulator shown, as is known, for example from German Patent Application 26 36 268, to form the first and second amplifier-limiters AL1 and AL2 in a different manner (for example, asymmetrically), to omit the second mixer stage M2 and to tune the tunable second IF filter RA1-RA3 and the FM demodulator DEM to the first intermediate frequency f1, to form the tunable second IF filter RA1-RA3 with a different number than the three cascade-arranged resonance amplifiers shown, for example two resonance amplifiers, to arrange in the FM receiver of Fig. 1 a low-pass filter (not shown) functioning as a loop filter between the output of the first amplifier-limiter AL1 and the common junction point of the connections to the tuning control inputs of the first to third resonance amplifiers RA1-RA3, or to use a single-phase mixer stage instead of the phase-quadrature mixer stage M2 shown, followed by a resonance amplifier as a phase splitter, as is known *per se* from the afore-mentioned European Patent Application no. 0 420 974. It is also feasible to use the afore-described tuning control in a conventional single-phase tunable IF circuit.

## Claims

1. An FM receiver comprising in cascade an RF section (RF0), a first tunable mixer stage (M1) for a frequency conversion of a desired RF FM reception signal into a first intermediate frequency signal, an IF device and an FM demodulator (DEM), means incorporated in the signal path of the FM receiver for converting a single-phase signal into a pair of signals in mutual phase quadrature, said pair of phase-quadrature signals being applied to in-phase (I) and quadrature (Q) signals paths of the IF device, said IF device comprising a polyphase IF filter including at least a first and second resonance amplifier connected in cascade and incorporated in said in-phase (I) and quadrature (Q) signal paths and having a resonance frequency and having a bandpass characteristic which is symmetrical around its resonance frequency, said polyphase IF filter being coupled to the FM demodulator (DEM), wherein each of said resonance amplifiers provides IF selectivity and each one of said resonance amplifiers (RA1, RA2) has a tuning control input (TI1, TI2) for controlling the tuning, while an output of the cascade arrangement of the at least first (RA1) and second (RA2) resonance amplifiers is coupled *via* the frequency demodulator (DEM) to a tuning control signal generating circuit (TC), at least first and second outputs of which are coupled to the tuning control inputs (TI1, TI2) of the first (RA1) and second (RA2) resonance amplifiers, respectively, said tuning control signal generating circuit (TC) deriving for each resonance amplifier (RA1, RA2) a tuning control signal from the output signal of the frequency demodulator (DEM) and thereby constituting at least first and second tuning control loops from the output to the tuning control input (TI1, TI2) of the first (RA1) and second (RA2) resonance amplifiers, respectively, **characterized in that** the open loop gain of each one of the at least first and second tuning control loops being smaller than one, and the bandwidth of the first tuning control loop is larger than that of the second tuning control loop.

2. An FM receiver as claimed in Claim 1, **characterized in that** the IF device comprises, consecutively coupled to the first mixer stage (M1), a first IF stage (IF1), a second mixer stage (M2) for a down-conversion of the first IF signal into a second IF signal, and a second IF stage, said second mixer stage being part of said means for converting a single-phase signal into a pair of signals in mutual phase quadrature and comprising an in-phase (M2i) and a quadrature (M2q) mixer circuit having a common signal input for applying the first IF signal thereto and an in-phase and a quadrature output, local in-phase and quadrature oscillator mixing signals being applied from a local oscillator (FO) to said in-phase (M2i) and quadrature (M2q) mixer circuits, respectively, for converting the first intermediate frequency signal into in-phase and quadrature components of the second IF signal, said polyphase IF filter being arranged between the in-phase and quadrature outputs of the second mixer stage (M2) and a pair of phase-quadrature inputs of the FM demodulator (DEM).

3. An FM receiver as claimed in Claim 1, **characterized in that** the tuning control signal generating circuit (TC) comprises an amplifier-limiter (AL1) coupled to the output of the frequency demodulator (DEM) and having a gain factor which is smaller than one, which amplifier-limiter (AL1) is active for each one of the two first and second tuning control loops and whose gain decreases gradually at an increasing input signal amplitude and supplies an output signal whose amplitude increases monotonically to a limitation value for a continuous and gradual limitation of the tuning control signal in each one of the two first and second tuning control loops at an increasing output signal amplitude of the FM demodulator (DEM).

4. An FM receiver as claimed in Claim 1, **characterized in that** the tuning control signal generating circuit (TC) comprises a cascade arrangement of first (AL1) and second (AL2) amplifier-limiters, outputs of which are coupled to the tuning control inputs (TI1, TI2) of the first (RA1) and second (RA2) resonance amplifiers, respectively, the gain factor of each one of the two first (AL1) and second (AL2) amplifier-limiters being smaller than one.

5. An FM receiver as claimed in Claim 1, **characterized in that** the first (AL1) and second (AL2) amplifier circuits in the tuning control signal generating circuit (TC) precede first (LP1) and second (LP2) loop filters, respectively.

6. An FM receiver as claimed in Claim 1, **characterized in that** the frequency demodulator (DEM) comprises a multiplier circuit and a frequency-dependent phase shifter, in which the polyphase IF filter is coupled to a first input of the multiplier circuit and to a second input of the multiplier circuit *via* the frequency-dependent phase shifter, said frequency-dependent phase shifter comprising a resonance amplifier.

## Patentansprüche

1. FM-Empfänger mit einer Kaskadenschaltung eines RF-Teils (RF0), einer ersten abstimmbaren Mischstufe (M1) zur Frequenzumwandlung eines gewünschten RF-FM-Empfangssignals in ein erstes Zwischenfrequenzsignal, mit einer ZF-Anordnung und einem FM-Demodulator (DEM), mit Mitteln, die in der Signalstrecke des FM-Empfängers vorgesehen sind zur Umwandlung eines Einphasensignals in ein Signalpaar mit zueinander quadratur verschobenen Phasen, wobei dieses genannte Paar von Phasen-Quadratrursignalen einer phasengleichen Signalstrecke (I) und einer Quadratursignalstrecke (Q) der ZF-Anordnung zugeführt werden, wobei die genannte ZF-Anordnung ein Polyphasen-ZF-Filter aufweist mit wenigstens einem ersten und einem zweiten Resonanzverstärker, die in Kaskade geschaltet sind und in den genannten phasengleichen (I) und Quadratursignalstrecken (Q) einverleibt sind und eine Resonanzfrequenz haben, sowie eine Bandpasscharakteristik haben, die symmetrisch um die Resonanzfrequenz liegt, wobei das genannte ZF-Filter mit dem FM-Demodulator (DEM) gekoppelt ist, wobei jeder der genannten Resonanzverstärker ZF-Selektivität schafft und jeder der genannten Resonanzverstärker (RA1, RA2) einen Abstimmregeleingang (TI1, TI2) hat zur Steuerung der Abstimmung, während ein Ausgang der Kaskadenschaltung des wenigstens ersten (RA1) und zweiten (RA2) Resonanzverstärkers über den Frequebademodulator (DEM) mit einer Schaltungsanordnung (TC) zum Erzeugen eines Abstimmregelsignals gekoppelt ist, von denen wenigstens der erste und der zweite Ausgang mit den Abstimmregeleingängen (TI1, TI2) des ersten (RA1) bzw. zweiten (RA2) Resonanzverstärkers gekoppelt ist, wobei die genannte Schaltungsanordnung (TC) zum Erzeugen des genannten Abstimmregelsignals für jeden Resonanzverstärker (RA1, RA2) ein Abstimmregelsignal aus dem Ausgangssignal des Frequenzdemodulators (DEM) herleitet und dadurch wenigstens eine erste und eine zweite Abstimmregelschleife von dem Ausgang zu dem Abstimmregeleingang (TI1, TI2) des ersten (RA1) und des zweiten (RA2) Resonanzverstärkers bildet, **dadurch gekennzeichnet, dass** die offene Schleifenverstärkung jeder der wenigstens ersten und zweiten Abstimmregelschaltungen kleiner als eins ist und dass die Bandbreite der ersten Abstimmregelschleife größer ist als die der zweiten Abstimmregelschleife.

2. FM-Empfänger nach Anspruch 1, **dadurch gekennzeichnet, dass** die ZF-Anordnung nacheinander mit der ersten Mischstufe (M1) gekoppelt die nachfolgenden Elemente umfasst: ein erste ZF-Stufe (IF1), eine zweite Mischstufe (M2) für eine Abwärtsmischung des ersten ZF-Signals in ein zweites ZF-Signal, und eine zweite ZF-Stufe, wobei die genannte Mischstufe einen Teil der genannten Mittel bilden zum Umwandeln eines Einphasensignals in ein Signalpaar zueinander in Phasenquadratur geschaltet, und mit einer phasengleichen (M2i) und einer Quadratur (M2q) Mischschaltung mit einem gemeinsamen Signaleingang zum Zuführen des ersten ZF-Signals zu derselben und mit einem phasengleichen und einem Quadraturausgang, wobei örtliche phasengleiche und Quadraturoszillatormischsignale von einem örtlichen Oszillator (FO) zu der genannten phasengleichen (M2i) bzw. der Quadraturmischschaltung (M2q) zugeführt werden zum Umwandeln des ersten Zwischenfrequenzsignals in phasengleiche und Quadraturanteile des zweiten ZF-Signals, wobei das genannte Polyphasen-ZF-Filter zwischen dem phasengleichen und dem Quadraturausgang der zweiten Mischstufe (M2) und einem Paar phasenquadratureingängen des FM-Demodulators (DEM) vorgesehen sind.

3. FM-Empfänger nach Anspruch 1, **dadurch gekennzeichnet, dass** die Schaltungsanordnung (TC) zum Erzeugen des Abstimmregelsignals einen Verstärkerbegrenzer (AL1) aufweist, der mit dem Ausgang des Frequenzdemodulators (DEM) gekoppelt ist und einen Verstärkungsfaktor aufweist, der kleiner ist als eins, wobei dieser Verstärkerbegrenzer (AL1) für jede der beiden ersten und zweiten Abstimmregelschleifen und deren Verstärkung bei einer zunehmenden Amplitude des Eingangssignals allmählich abnimmt und ein Ausgangssignal liefert, dessen Amplitude monoton zu einem Grenzwert für eine kontinuierliche und allmähliche Begrenzung des Abstimmregelsignals in jeder der beiden ersten und zweiten Abstimmregelschleifen bei einer zunehmenden Amplitude des Ausgangssignals des FM-Demodulators (DEM) zunimmt.

4. FM-Empfänger nach Anspruch 1, **dadurch gekennzeichnet, dass** die Schaltungsanordnung (TC) zum Erzeugen des Abstimmregelsignals eine Kaskadenschaltung des ersten (AL1) und des zweiten (AL2) Verstärkerbegrenzers aufweist, deren Ausgänge mit den Abstimmregeleingängen (TI1, TI2) des ersten (RA1) bzw. des zweiten (RA2) Resonanzverstärkers gekoppelt sind, wobei der Verstärkungsfaktor jedes der beiden ersten (AL1) und zweiten (AL2) Verstärkerbegrenzers kleiner ist als eins.

5. FM-Empfänger nach Anspruch 1, **dadurch gekennzeichnet, dass** der ersten (AL1) und der zweiten (AL2) Verstärkerschaltung in der Schaltungsanordnung (TC) zum Erzeugen des Abstimmregelsignals ein erstes (LP1) bzw. ein zweites (LP2) Schleifenfilter vorgeschaltet ist.

6. FM-Empfänger nach Anspruch 1, **dadurch gekennzeichnet, dass** der Frequenzdemodulator (DEM) eine Multiplizierschaltung und einen frequenzabhängigen Phasenschieber umfasst, wobei das Polyphasen-ZF-Filter mit einem ersten Eingang der Multiplizierschaltung gekoppelt ist, sowie über den frequenzabhängigen Phasenschieber mit einem zweiten Eingang der Multiplizierschaltung gekoppelt ist, wobei der genannte frequenzabhängige Phasenschieber einen Resonanzverstärker umfasst.

## Revendications

1. Récepteur FM comportant en cascade une partie RF (RF0), un premier étage mélangeur accordable (M1) pour une conversion de fréquence d'un signal de réception FM radiofréquence souhaité en un premier signal à fréquence intermédiaire, un dispositif IF et un démodulateur FM (DEM), des moyens étant incorporés dans le trajet de signaux du récepteur FM pour convertir un signal monophasé en une paire de signaux à quadrature de phase mutuelle, ladite paire de signaux à quadrature de phase étant appliqués à des trajets de signaux en phase (I) et en quadrature (Q) du dispositif IF, ledit dispositif IF comportant un filtre IF polyphasé incorporant au moins des premier et deuxième amplificateurs de résonance qui sont connectés en cascade et qui sont incorporés dans lesdits trajets de signaux en phase (I) et en quadrature (Q) et ayant une fréquence de résonance et ayant une caractéristique passe-bande qui est symétrique autour de sa fréquence de résonance, ledit filtre IF polyphasé étant couplé au démodulateur FM (DEM) dans lequel chacun desdits amplificateurs de résonance fournit une sélectivité IF et dans lequel chacun desdits amplificateurs de résonance (RA1, RA2) présente une entrée de commande d'accord (TI1, TI2) pour commander l'accord, alors qu'une sortie du montage en cascade des au moins premier (RA1) et deuxième (RA2) amplificateurs de résonance est couplée par l'intermédiaire du démodulateur de fréquence (DEM) à un circuit générateur de signaux de commande d'accord (TC) dont au moins des première et deuxième sorties sont couplées respectivement aux entrées de commande d'accord (TI1, TI2) des premier (RA1) et deuxième (RA2) amplificateurs de résonance, ledit circuit générateur de signaux de commande d'accord (TC) dérivant pour chaque amplificateur de résonance (RA1, RA2) un signal de commande d'accord à partir du signal de sortie du démodulateur de fréquence (DEM) et constituant de ce fait respectivement au moins des première et deuxième boucles de commande d'accord s'étendant à partir de la sortie vers l'entrée de commande d'accord (TI1, TI2) des premier (RA1) et deuxième (RA2) amplificateurs de résonance, **caractérisé en ce que** le gain de la boucle ouverte de chacune des au moins première et deuxième boucles de commande d'accord est inférieur à un et **en ce que** la largeur de bande de la première boucle de commande d'accord est supérieure à celle de la deuxième boucle de commande d'accord,

2. Récepteur FM selon la revendication 1, **caractérisé en ce que** le dispositif IF comporte, couplés consécutivement au premier étage mélangeur (M1), un premier étage IF (IF1), un deuxième étage mélangeur (M2) pour une conversion en bas du premier signal IF en un deuxième signal IF, et un deuxième étage IF, ledit deuxième étage mélangeur faisant partie desdits moyens pour convertir un signal monophasé en une paire de signaux à quadrature de phase mutuelle et comportant un circuit mélangeur en phase (M2i) et en quadrature (M2q) ayant une entrée de signal commune pour y appliquer le premier signal IF et une sortie en phase et en quadrature, des signaux de mélange oscillateurs en phase et en quadrature locaux étant appliqués respectivement à partir d'un oscillateur local (FO) auxdits circuits mélangeurs en phase (M2i) et en quadrature (M2q) pour convertir le premier signal à fréquence intermédiaire en des composantes en phase et en quadrature du deuxième signal IF, ledit filtre IF polyphasé étant disposé entre des sorties en phase et en quadrature du deuxième étage mélangeur (M2) et une paire d'entrées en phase-quadrature du démodulateur FM (DEM).

3. Récepteur FM selon la revendication 1, **caractérisé en ce que** le circuit générateur de signaux de commande d'accord (TC) comporte un limiteur d'amplificateur (AL1) étant couplé à la sortie du démodulateur de fréquence (DEM) et ayant un facteur de gain qui est inférieur à un, ledit limiteur d'amplificateur (AL1) étant actif pour chacune des première et deuxième boucles de commande d'accord et dont le gain diminue graduellement dans le cas d'une amplitude croissante du signal d'entrée et délivrant un signal de sortie dont l'amplitude augmente d'une manière monotone à une valeur de limitation pour une limitation continue et graduelle du signal de commande d'accord dans chacune des première et deuxième boucles de commande d'accord dans le cas d'une amplitude croissante du signal de sortie du démodulateur FM (DEM).

4. Récepteur FM selon la revendication 1, **caractérisé en ce que** le circuit générateur de signaux de commande d'accord (TC) comporte un montage en cascade des premier (AL1) et deuxième (AL2) limiteurs d'amplificateur dont les sorties sont couplées respectivement aux entrées de commande d'accord (TI1, TI2) des premier (RA1) et deuxième (RA2) amplificateurs de résonance, le facteur de gain de chacun des deux premier (AL1) et deuxième (AL2) limiteurs d'amplificateur étant inférieur à un.

5. Récepteur FM selon la revendication 1, **caractérisé en ce que** les premier (AL1) et deuxième (AL2) montages amplificateurs présents dans le circuit générateur de signaux de commande d'accord (TC) précèdent respectivement des premier (LP1) et deuxième (LP2) filtres bouclés.

6. Récepteur FM selon la revendication 1, **caractérisé en ce que** le démodulateur de fréquence (DEM) comporte un circuit multiplicateur et un déphaseur dépendant de fréquence où le filtre IF polyphasé est couplé à une première entrée du circuit multiplicateur et à une deuxième entrée du circuit multiplicateur par l'intermédiaire du déphaseur dépendant de fréquence, ledit déphaseur dépendant de fréquence comportant un amplificateur de résonance.
